# EUROPÄISCHE PATENTSCHRIFT

(11) **EP 3 766 087 B1**
(45) Veröffentlichungstag und Bekanntmachung des Hinweises auf die Patenterteilung: **14.02.2024**
(21) Anmeldenummer: 18723426.5
(22) Anmeldetag: 20.04.2018
(51) Int. Cl.: H01F 27/40, H01F 27/02, H01F 27/12

(54) **SENSFORMER**
SENSFORMER
TRANSFORMATEUR CONNECTÉ

(43) Veröffentlichungstag der Anmeldung: 20.01.2021
(73) Patentinhaber: Siemens Energy Global GmbH & Co. KG, 81739 München (DE)
(72) Erfinder: BAJAI, Laszlo, 2185 Váckisújfalu (HU); MORENO STUCK, Bruno, 90419 Nürnberg (DE); KEMPER, Tobias, 90478 Nürnberg (DE)
(86) Internationale Anmeldenummer: PCT/EP2018/060223
(87) Internationale Veröffentlichungsnummer: WO 2019/201451

(56) Entgegenhaltungen:
- EP-A1- 1 470 948
- WO-A1-2016/066373

## Beschreibung

Die Erfindung betrifft ein elektrisches Gerät nach dem Oberbegriff von Anspruch 1.

Ein solches elektrisches Gerät ist beispielsweise aus der WO 2016/066373 A1 bekannt. Dort ist ein Transformator gezeigt, der mit Temperatursensoren bestückt ist. Die Temperatursensoren sind mit einem System verbunden, das die Messwerte mittels eines Prozessors und einer Speichereinheit auswertet. Das System verfügt ferner über Kommunikationsmittel zur Verbindung mit einer an einem anderen Ort befindlichen Zentraleinheit. Bei dem Transformator handelt es sich um einen Verteiltransformator, der in einem Verteilnetz im Mittelspannungsbereich angeordnet ist. Das Verteilnetz ist mit Strom- und Spannungssensoren ausgebildet, die ebenfalls mit dem System verbunden ist.

Weiterer Stand der Technik ist in der EP 1 470 948 A1 offenbart.

Die WO 2012/142355 A1 offenbart eine Reihe von Transformatoren, die mit so genannten "Online-Sensoren" bestückt sind. Die Online-Sensoren erfassen beispielsweise die Feuchtigkeit im Öl eines Transformators, den Zustand seiner Durchführung, eines Stufenschalters oder Kühlsystems. Darüber hinaus wird vorgeschlagen, Online-Sensoren für die obere Öltemperatur, die Wicklungstemperatur, den Status von Relais, wie beispielsweise das Buchholzrelais, zu erfassen und an ein zentrales Rechensystem zu übertragen. Das zentrale Rechensystem ist ferner mit so genannten "Offline-Daten" versorgbar, und umfasst sowohl Hard- als auch Softwarekomponenten. Das zentrale Rechensystem wertet die Messsignale aus, so dass Aussagen dahin möglich sind, ob der mit dem jeweiligen Onli-ne-Sensor bestückte Transformator demnächst gewartet werden muss oder gefahrläuft auszufallen.

Als Transformatoren ausgestaltete elektrische Geräte dienen zum Umwandeln einer Oberspannung in eine Unterspannung oder umgekehrt und werden im gesamten Bereich der Elektroenergie-übertragung und -Verteilung eingesetzt. Leistungstransformatoren werden für die Übertragungen elektrischer Energie über lange Strecken unter Hochspannungen im Bereich von etwa 50 kV bis 1000 kV eingesetzt. Insbesondere bei hohen Betriebsspannungen können Leistungstransformatoren ein Gewicht von mehreren hundert Tonnen aufweisen und der Größe eines Einfamilienhauses entsprechen. Verteiltransformatoren sind vergleichsweise kompakt und können beispielsweise auch an einem Strommast oder einem Schienenfahrzeug befestigt werden. Allen Transformatoren ist gemein, dass diese einen Kern und induktiv miteinander gekoppelte Wicklungen aufweisen. Die Wicklungen liegen während des Betriebs auf einem Hochspannungspotenzial. Zur Isolierung und Kühlung der Wicklung dient ein Isolierstoff, der im Fall von Leistungstransformatoren ein Fluid, beispielsweise ein Öl, eine Esterflüssigkeit oder aber auch ein Gas sein kann.

Auch Verteiltransformatoren können einen mit Isolierfluid befüllten Kessel aufweisen. Abweichend hiervon ist es jedoch auch möglich, die Verteiltransformatoren als so genannte Trockentransformatoren auszugestalten, wobei statt eines flüssigen oder gasförmigen Isoliermediums die Wicklungen in einem Festkörper, beispielsweise einem Epoxidharz eingebettet sind.

Im Fehlerfall stellen Transformatoren ein für die Sicherheit der Netzwerkversorgung kritisches Bauteil dar, da durch den Ausfall des Transformators die Energieversorgung unterbrochen wird. Es ist daher wünschenswert, den Zustand des Transformators von fern und somit online überwachen zu können, um einem Ausfall möglichst vorzubeugen.

Dem eingangs genannten elektrischen Gerät haftet der Nachteil an, dass es sich bei den am Verteiltransformator angeordneten Sensoren ausschließlich um eine fest vorgegebene Anzahl von Temperatursensoren handelt.

Aufgabe der Erfindung ist es, ein elektrisches Gerät der eingangs genannten Art bereitzustellen, das kostengünstig ist und gleichzeitig im gesamten Bereich der Energieübertragung und -Verteilung flexibel an die jeweils vorliegenden Anforderungen angepasst werden kann.

Die Erfindung löst diese Aufgabe durch die kennzeichnenden Merkmale von Anspruch 1.

Das erfindungsgemäße elektrische Gerät ist mit einer Kommunikationseinheit bestückt, die ein Gehäuse mit mehreren Messeingängen aufweist, so dass eine ganze Reihe unterschiedlicher Sensoren, die in dem elektrischen Gerät angeordnet sind, flexibel mit der jeweiligen Kommunikationseinheit verbunden werden können. Ist beispielsweise das elektrische Gerät ein Transformator, der in einem Übertragungsnetz mit Spannungen über 50 kV eingesetzt wird, weist dieser in der Regel einen Kessel oder Tank auf, der mit einem Isolierfluid befüllt ist. Innerhalb des Tanks sind Kern und Wicklung angeordnet. In diesem Falle sind in der Regel Temperatursensoren erforderlich, die zum Erfassen der Fluidtemperatur im Kessel dienen. Im Gegensatz dazu weisen so genannte Trockentransformatoren, die zur Energieverteilung in Verteilnetzen mit Spannungen bis zu 50 kV eingesetzt werden, abweichende Sensoren auf, die beispielsweise zum Erfassen einer Wicklungstemperatur oder eines Wicklungsstromes eingerichtet sind. Um für alle elektrischen Geräte die gleiche Kommunikationseinheit verwenden zu können, ist diese im Rahmen der Erfindung mit mehreren analogen und digitalen Eingängen bestückt. Darüber hinaus ist er findungsgemäß ein so genanntes GSM-Modul vorgesehen, mit dem die von der Kommunikationseinheit gesammelten Messsignale über einen bekannten Standard an eine ferngelegene, beispielsweise cloudbasierte Recheneinheit übertragen werden können. Dort kann anschließend die zentrale Überwachung mehrerer, auch verteilt aufgestellter elektrischer Geräte erfolgen. Die große Anpassfähigkeit der Kommunikationseinheit an die jeweils erforderlichen Sensoren auf der einen Seite und die gemeinsame Übertragung der bereits verarbeiteten Messsignale auf der anderen Seite bieten einen entscheidenden Vorteil gegenüber dem eingangs genannten System mit einer ganzen Reihe von getrennt netzwerkfähigen Sensoren. Dabei ist es im Rahmen der Erfindung auch möglich, dass das elektrische Gerät Sensoren aufweist, die nicht mit der Kommunikationseinheit verbunden sind.

Die Kommunikationseinheit verfügt im Rahmen der Erfindung über ein Gehäuse, das zur Aufnahme seiner elektronischen Komponenten sowie zur deren gemeinsamer Halterung dient. Das Gehäuse ist vorteilhafterweise aus einem Kunststoff, einem gesinterten Material oder Metall gefertigt und kann beispielsweise in einem Schaltschrank des elektrischen Gerätes angeordnet sein. Bei einigen elektrischen Geräten ist die Anordnung der Kommunikationseinheit in einem Schaltschrank oder einer sonstigen Komponente des elektrischen Geräts, welche den notwendigen Schutz vor Verunreinigungen oder schädlichen Wetterbedingungen bereitstellt, nicht möglich oder unerwünscht. In diesen Fällen verfügt die Kommunikationseinheit über ein Schutzgehäuse, das ebenfalls vorteilhafterweise aus einem Kunststoff, einem gesinterten Material oder Metall ge fertigt ist und in dem alle restlichen Komponenten der Kommunikationseinheit angeordnet sind. Bevorzugt verfügt die Kommunikationseinheit über ein Gehäuse und ein Schutzgehäuse, welchen das Gehäuse schützend kapselt. Das Schutzgehäuse ist mit Signalkabeldurchführungen ausgerüstet, die ein Hindurch führen von Signalkabeln durch die Wandung des Schutzgehäuses ermöglichen. Dabei können mehrere Signalkabel gemeinsam durch eine Signalkabeldurchführung geführt sein. Das wetterfeste Schutzgehäuse ist bevorzugt mit Befestigungsmitteln ausgerüstet, mit deren Hilfe die Kommunikationseinheit beispielsweise außen an dem im Freien aufgestellten elektrischen Gerät befestigt ist. Insbesondere im Falle von Verteiltransformatoren ist es jedoch auch möglich, dass diese in einem Gebäude angeordnet sind, wobei Kommunikationseinheit an einer Wand des Gebäudes innen oder außen befestigt ist.

Um die Anwendungsvielfalt der analogen Eingänge zu erweitern, ist erfindungsgemäß für jeden analogen Eingang eine Energieversorgung umfassend eine Energiequelle, einen Überstromschutz und einen Polarisationsschutz vorgesehen.

Im Rahmen der Erfindung ist das elektrische Gerät bevorzugt ein Transformator oder eine Drossel. Ferner ist es möglich, dass das elektrische Gerät mehrere Kommunikationseinheiten aufweist, wobei jedoch jede Kommunikationseinheit mit mehreren Sensoren verbunden ist.

Vorteilhafterweise umfasst die Gruppe von Messsensoren einen Wicklungsstromsensor, der zum Erfassen eines durch die Wicklung fließenden Wicklungsstromes eingerichtet ist, und einen Positionsgeber, der zur Bestimmung der örtlichen Lage des elektrischen Gerätes dient. Gemäß dieser vorteilhaften Weiterentwicklung werden Messsensoren eingesetzt, die sowohl für elektrische Geräte, die einen mit Isolierfluid befüllten Kessel aufweisen, als auch für feststoffisolierte elektrische Geräte geeignet sind. Die besagten Sensoren können unabhängig vom Typ des jeweiligen elektrischen Geräts eingesetzt werden. Auf diese Weise lassen sich Kosten einsparen. Der Positionsgeber kann grundsätzlich beliebig ausgeführt sein. Beispiels weise ist der Positionsgeber eine auf einer Speichereinheit der Kommunikationseinheit abgelegte Ortsangabe, die von außen auslesbar ist. Bevorzugt ist der Positionsgeber jedoch als GPS-Antenne ausgeführt, die von im Orbit kreisenden Satelliten erfasst werden kann. GPS steht hier für das Fachleuten bekannte Global Positioning System.

Darüber hinaus verfügt die Kommunikationseinheit über ein Widerstandsthermometer. Widerstandsthermometer umfassen in der Regel eine Messsonde aus einem Material, dessen elektrischer Widerstand temperaturabhängig ist. Beispielsweise weist die Messsonde eine Platinmatrix auf und hat einen Ruhewiderstand von etwa 100 Ohm. Ein solcher Widerstandstemperatursensor wird auch als PT-100-Sensor bezeichnet. PT-100-Sensoren sind in der Regel durch mehradrige Kabel mit der Kommunikationseinheit verbunden, die einen passenden Eingang für diese Messsensoren aufweist. Dadurch wird die Flexibilität für den Einsatz des Kommunikationsmoduls erhöht.

Darüber hinaus kann es vorteilhaft sein, dass jede Kommunikationseinheit über einen USB-Anschluss und einen so genannten Ethernet-Anschluss verfügt. Die USB- oder Ethernet-Anschlüsse dienen zum Auslesen der gespeicherten Parameter der Kommunikationseinheit vor Ort und/oder zum Zugriff auf eine Logikeinheit, die Teil der Kommunikationseinheit ist, und mit deren Hilfe die Wirkungsweise der Kommunikationseinheit beim Erfassen und Verarbeiten der empfangenen Messsignale eingestellt werden kann. Der Ethernet-Anschluss ermöglicht ferner die Verbindung mit dem Internet.

Vorteilhafterweise ist der Positionsgeber außerhalb des Gehäuses der Kommunikationseinheit angeordnet. Als Positionsgeber kommt - wie weiter oben bereits ausführt - eine so genannte GPS-Antenne in Betracht. Die GPS (Global Positioning System) -Antenne muss zur Positionsbestimmung von Satelliten erfasst werden. Aufgrund der lösbaren Befestigung des Positionsgebers kann dieser von der Kommunikationseinheit getrennt und beispielsweise außerhalb des Gebäudes angeordnet werden, das eine im Inneren angeordnete Antenne ansonsten abschirmen würde. Die GPS-Antenne kann vorteilhafterweise über einen GPS-Signaleingang mit den restlichen Komponenten der Kommunikationseinheit verbunden werden.

Zur Zeitsignalisierung kann die Kommunikationseinheit über einen internen Zeitgeber verfügen. Der Zeitgeber kann beispielsweise über eine GPS-Antenne erfolgen. Abweichend davon ist ein zusätzlicher Zeitgeber vorgesehen, der nach einem so genannten NTP-Zeitsynchronisationsprotokoll arbeitet.

Gemäß einer abweichenden Variante verfügt das elektrische Gerät über einen mit Isolierfluid befüllten Kessel, wobei die Gruppe von Sensoren einen Temperatursensor im oberen Bereich des Kessels und einen Temperatursensor im unteren Bereich des Kessels umfasst, die jeweils zum Erfassen der Temperatur des Isolierfluids eingerichtet sind. Gemäß dieser Variante sind Messsensoren vorgesehen und mit der Kommunikationseinheit verbunden, die zum Erfassen der oberen und unteren Temperatur des Isolierfluids eingerichtet sind. Abweichend hiervon wird die Temperatur des Isolierfluids lediglich an einer Seite des Kessels des elektrischen Geräts erfasst.

Gemäß einer weiteren Variante ist jede Wicklung in einem elektrisch nichtleitenden Festkörper eingebettet und mit einem Wicklungstemperatursensor bestückt, der zum Erfassen der Temperatur der Wicklung eingerichtet ist. Solche Wicklungstemperatursensoren werden bevorzugt für so genannte Trockentransformatoren verwendet.

Vorteilhafterweise verfügt die Kommunikationseinheit über einen Coprozessor, der eingangsseitig mit den Messeingängen und ausgangsseitig mit einem Hauptprozessor verbunden ist, wobei eine Speichereinheit vorgesehen ist, die mit dem Hauptprozessor verbunden ist. Die Aufteilung der Rechenleistung ist vor teilhaft und sorgt für einen fehlerfreien Betrieb der Kommunikationseinheit.

Gemäß einer diesbezüglich zweckmäßigen Weiterentwicklung ist der Coprozessor zum Empfang und zum Abtasten der Messsignale unter Erhalt von Messwerten, zum Digitalisieren der Messwerte unter Erhalt von Messdaten, Mitteln der digitalisierten Messdaten und zum Weitersenden der gemittelten Messdaten an den Hauptprozessor eingerichtet. Der Coprozessor dient somit zur Vorverarbeitung und insbesondere zum Zusammenstellen von Messdatenpaketen, die die Messdaten der verschiedenen Sensoren enthalten. Dabei sind die Messdaten eines Messdatenpakets gemittelt. Die Messdatenpakete werden dem Hauptprozessor weitergeleitet. Bevorzugt wird über eine Sekunde gemittelt, wo bei der Coprozessor jede Sekunde den Mittelwert der Messdaten bildet, die er von den verschiedenen Messsignalen der Messsensoren abgeleitet hat. Selbstverständlich kann die Dauer der Mittelung des Coprozessors durch entsprechende Parametrisierung der Kommunikationseinheit verändert werden, so dass die Zeitdauer der Mittelung verändert ist.

Gemäß einer diesbezüglich zweckmäßigen Weiterentwicklung ist der Hauptprozessor zum Empfang der digitalen gemittelten Messdaten und deren Weiterverarbeitung unter Gewinnung von verarbeiteten Messdaten, zum Speichern der verarbeiteten Messdaten in der Speichereinheit und zum Übersenden der überarbeiteten Messdaten an das GSM-Modul eingerichtet. Die vor verarbeiteten Messdaten werden im Rahmen der Erfindung dem Hauptprozessor zur Verfügung gestellt, der beispielsweise ei ne weitere Mittelung der im Sekundentakt eintreffenden Messdaten durchführt und diese beispielsweise über eine Minute hinweg mittelt und die erneut gemittelten Messdaten in der Speichereinheit ablegt. Diese Messdaten werden gleichzeitig über das GSM-Modul an die zentrale Recheneinheit weitergeleitet. Auch der Mittelungszeitraum des Hauptprozessors kann durch entsprechende Parametrisierung eingestellt werden.

Zweckmäßigerweise verfügt die Kommunikationseinheit über eine Logikeinheit. Die Logikeinheit kann beispielsweise über die USB-Schnittstelle oder über den Ethernet-Eingang angesprochen werden. Darüber hinaus dient die Logikeinheit auch dazu, das so genannte GSM-Modul anzusteuern oder über das GSM-Modul von einer Cloud angesteuert zu werden. Bei der Logikeinheit handelt es sich um eine Software, die Anfragen, Eingangsbefehle oder Parameter von den besagten Schnittstellen empfängt und entsprechende Anweisungen ausführt.

Zweckmäßigerweise weist die Kommunikationseinheit ein mit Zugangsöffnungen ausgerüstetes Schutzgehäuse auf, in dem das Gehäuse vollständig gekapselt angeordnet ist. Das Schutzgehäuse dient zum Schutz der elektronischen Komponenten der Kommunikationseinheit vor Schmutz und sonstigen schädlichen Umwelteinflüssen wie z.B. Schnee, Regen, Sonneneinstrahlung sowie außerordentlich hohen oder niedrigen Temperaturen. Die Signalleitungen können dem Gehäuse mit den Messeingängen durch die Zugangsöffnungen zugeführt werden. Dabei können auch mehrere Signalleitungen durch eine Zugangsöffnung geführt werden.

Das Schutzgehäuse verfügt beispielsweise über Befestigungsmittel zum Befestigen der Kommunikationseinheit direkt an den anderen Komponenten des elektrischen Geräts. Bei einer Vari ante ist die Kommunikationseinheit innerhalb eines Schaltschranks angeordnet. Ein ohnehin vorhandener Schaltschrank kann im Rahmen der Erfindung zur Aufnahme der Kommunikationseinheit genutzt werden.

Die Verbindung der in dem elektrischen Gerät angeordneten Messsensoren mit der Kommunikationseinheit ist grundsätzlich beliebig und erfolgt ganz allgemein über eine Datenverbindungsstrecke. Die Datenverbindungsstrecke kann beispielsweise als Signalkabel ausgeführt sein, wobei die Signalkabel beispielsweise aus einem mit Isolierfluid befüllten Tank fluid dicht herausgeführt sind. Abweichend hiervon ist jedoch auch eine kabellose Übertragung der Messsignale an die Kommunikationseinheit im Rahmen der Erfindung möglich.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleichwirkende Bauteile verweisen und wobei
- Figur 1: ein Ausführungsbeispiel des erfindungsgemäßen elektrischen Geräts in einer schematischen Seitenansicht,
- Figur 2: ein weiteres Ausführungsbeispiel des elektrischen Geräts in schematischer Darstellung,
- Figur 3: ein Ausführungsbeispiel der Kommunikationseinheit eines elektrischen Geräts gemäß Figur 1 oder 2 in einer logischen Darstellung,
- Figur 4: ein Ausführungsbeispiel eines analogen Messeingangs einer Kommunikationseinheit gemäß Figur 3,
- Figur 5: ein Ausführungsbeispiel eines PT100-Eingangs der Kommunikationseinheit gemäß Figur 3,
- Figur 6: ein Ausführungsbeispiel für ein Schutzgehäuse der Kommunikationseinheit,
- Figur 7: ein weiteres Ausführungsbeispiel des erfindungsgemäßen Geräts,
- Figur 8: ein von Figur 7 abweichendes Ausführungsbei spiel des erfindungsgemäßen Geräts und
- Figur 9: ein Ausführungsbeispiel eines lösbaren Positionsgebers schematisch verdeutlichen.

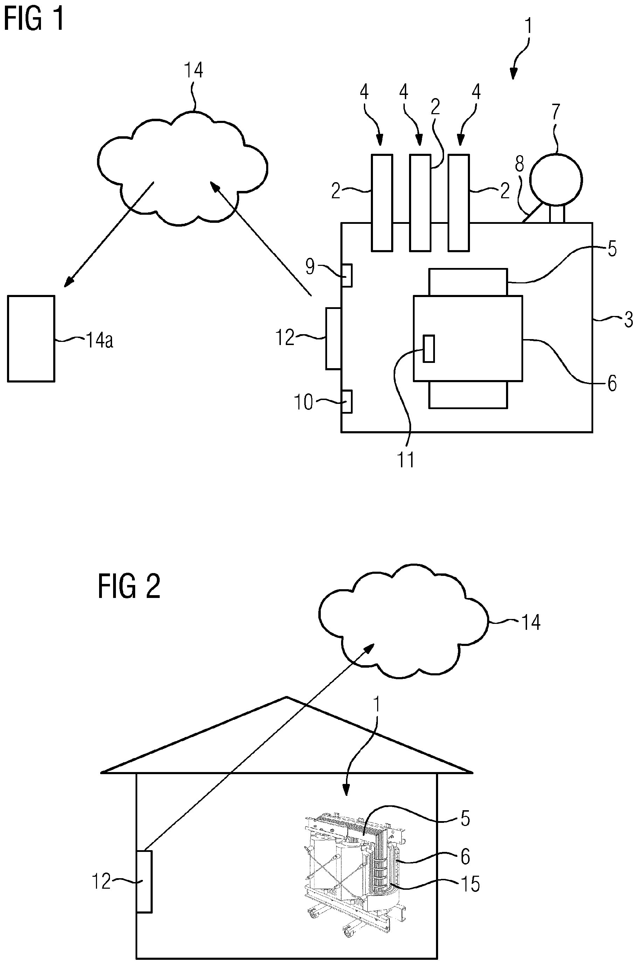

Figur 1 zeigt ein Ausführungsbeispiel des erfindungsgemäßen elektrischen Geräts, das hier als Transformator 1 ausgeführt ist. Der dargestellte Transformator 1 ist ein Leistungstransformator und zum Anschluss an ein 345 kV Hochspannungsnetz vorgesehen. Für jede Phase der Wechselspannung führenden Hochspannungsnetzes ist eine Hochspannungsdurchführung 2 vor gesehen, die über figürlich nicht dargestellte Befestigungsmittel an einem Kessel 3 des Transformators 1 befestigt ist. An ihrem von den Befestigungsmitteln abgewandten Ende ist je de Hochspannungsdurchführung 2 mit einem Freiluftanschluss ausgestattet, der zur Montage einer luftisolierte Freiluftleitung dient. Innerhalb des Kessels 3 ist ein Kern 5 angeordnet, der aus einem magnetisierbaren Material, hier Eisen, besteht. Dabei bildet der Kern 5 einen geschlossenen Magnet kreis aus und verfügt über drei Kernschenkel, von denen in Figur 1 nur einer erkennbar ist. Die Kernschenkel sind jeweils von konzentrisch zueinander angeordneten Wicklungen umschlossen, wobei in Figur 1 lediglich eine Oberspannungswicklung 6 erkennbar ist, welche eine innere Unterspannungswicklung und eine Hilfswicklung umschließt. Jede Oberspannungswicklung 6 ist über eine Verbindungsleitung, die figürlich nicht dargestellt ist, mit einer der dargestellten Hochspannungsdurchführungen 2 verbunden. Die Unterspannungswicklungen sind über ebenfalls nicht gezeigte Verbindungsleitungen mit Ausgangsdurchführungen und/oder mit Kabelsteckbuchsen verbunden. Der Transformator 1 transformiert die Eingangsspannung, hier 345 kV, auf eine kleinere Ausgangsspannung, hier 175,5 kV.

Zur Kühlung und elektrischen Isolierung des den Kern 5 und die Wicklungen 6 umfassenden Aktivteils ist der Kessel 3 mit einem Isolierfluid, hier einem Esteröl, befüllt, wobei zum Ausgleich temperaturbedingter Volumenschwankungen des Esterfluids ein Ausgleichsbehälter 7 vorgesehen ist, der über eine Verbindungskanal 8 mit dem Innenraum des Kessels 3 verbunden ist. Im oberen Bereich des Kessels 3 ist an seiner Innenwandung ein Temperatursensor 9 erkennbar, wobei im unteren Bereich des Kessels 3 ein weiterer Temperatursensor 10 angebracht ist. Die Temperatursensoren 9 und 10 sind zum Erfassen der dort jeweils herrschenden Temperatur des Isolierfluids, also der Esterflüssigkeit, eingerichtet. Darüber hinaus ist ein Temperatursensor 11 vorgesehen, der zum Messen der Wicklungstemperatur der Oberspannungswicklung 6 vorgesehen ist. Die Sensoren 9, 10 und 11 sind über nicht gezeigte Signalleitungen mit einer Kommunikationseinheit 12 verbunden, auf die später noch genauer eingegangen werden wird.

Die Kommunikationseinheit 12 sammelt die eingehenden Messsignale, digitalisiert diese unter Gewinnung von Messdaten und mittelt diese über eine vorgegebene Zeitdauer hinweg. Schließlich werden die gemittelten Messdaten in einer Speichereinheit der Kommunikationseinheit abgelegt, die in Figur 1 figürlich nicht dargestellt ist. Darüber hinaus verfügt die Kommunikationseinheit 12 über ein GSM-Modul, das die Kommunikation mit einer Recheneinheit 14a ermöglicht, die auch als Bestandteil einer so genannten Cloud 14 bezeichnet werden kann. Die gemittelten Messdaten werden dem GSM-Modul zugeführt und von diesem an die Cloud 14 übertragen.

Figur 2 zeigt ein weiteres Ausführungsbeispiel des erfindungsgemäßen elektrischen Geräts, das wieder als Transformator 1 ausgeführt ist, wobei es sich bei dem Transformator 1 jedoch um einen so genannten Trockentransformator 1 handelt. Auch hier umfasst der Transformator 1 einen Kern 5, der aus einem oberen horizontal verlaufenden Joch und drei senkrechten Schenkeln besteht, die jeweils von mehreren konzentrischen Wicklungen umschlossen sind, wobei die Oberspannungswicklungen 6 und eine Unterspannungswicklung 15 in der gezeigten Schnittansicht erkennbar sind. Der Kern 5 ist, wie üblich, aus aneinander anliegenden Eisenblechen ausgebildet, so dass Wirbelströme unterdrückt werden. Der Transformator 1 ist ferner mit figürlich nicht dargestellten Sensoren ausgerüstet, wobei ein nicht dargestellter Temperatursensor zum Erfassen der Wicklungstemperatur dient. Darüber hinaus wird mit Hilfe eines Strommesssensors der jeweilige Wicklungsstrom gemessen. Die Sensoren sind über ebenfalls nicht gezeigte Signalleitungen mit der Kommunikationseinheit 12 verbunden, die wieder mit einem GSM-Modul bestückt ist und die von den Messsensoren erhaltenen Messsignale sammelt und mittelt und bearbeitet und an die Cloud 14 zu Überwachungszwecken sendet. Selbstverständlich ist es im Rahmen der Erfindung auch möglich, die Kommunikationseinheit direkt an einem Trockentransformator zu befestigen.

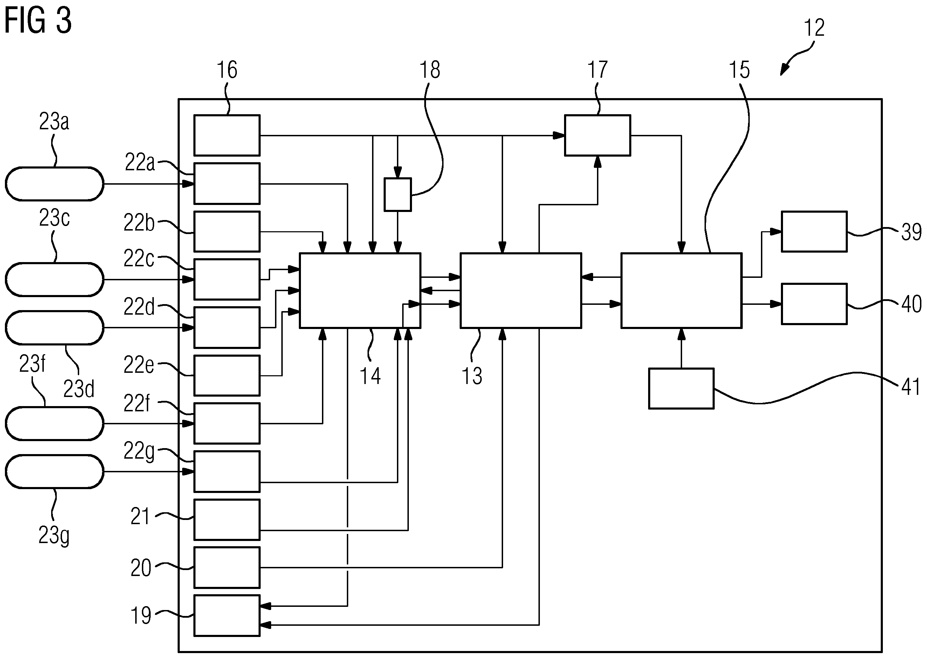

Figur 3 zeigt den Aufbau der Kommunikationseinheit 12 in einer logischen Darstellung. So weist die Kommunikationseinheit 12 einen Hauptprozessor 13 sowie einen Coprozessor 14 auf, die in einem in Figur 3 nicht dargestellten Gehäuse angeordnet sind. Darüber hinaus ist das bereits beschriebene GSM-Modul 15 gezeigt. Zur Energieversorgung ist ein Netzversorgungseingang 16 vorgesehen, mit dem der Coprozessor 14 und der Hauptprozessor 13 mit elektrischer Energie versorgt werden können. Ferner ist ein Energieschalter 17 erkennbar, der von dem Hauptprozessor 13 aus ansteuerbar ist, um das GSM-Moduls 15 mit dem Netzversorgungseingang zu verbinden bzw. von diesen zu trennen. Ferner ist eine Energiespeichereinheit 18 vorgesehen, die beispielsweise als wiederaufladbarer Akkumulator oder als Batterie ausgeführt ist.

Der Hauptprozessor 13 und der Coprozessor 14 sind mit einer Statusanzeige 19 gekoppelt, die von außen in Augenschein genommen werden kann und bei der es sich bei dem gezeigten Ausführungsbeispiel um eine optische Statusanzeige 19 in Gestalt von LEDs handelt. Die LEDs zeigen den jeweiligen Zustand des Hauptprozessors 13 und des Coprozessors 14 an. Oberhalb der Statusanzeige 19 ist ein Etherneteingang 20 und darüber ein so genannter USB-Anschluss 21 erkennbar. Der USB-Anschluss 21 ist mit dem Coprozessor 14 und der Ethernetanschluss 20 mit dem Hauptprozessor 13 verbunden.

Ferner sind Messeingänge 22a bis 22g erkennbar, die ausgangs seitig an den Coprozessor 14 angeschlossen sind. Bei den Messeingängen 22a und 22b handelt es sich um so genannte digitale Eingänge. Die Messeingänge 22c, 22d und 22e sind als analoge Eingänge ausgestaltet. Der Messeingang 22f ist ein Eingang für ein Widerstandsthermometer, das als so genannter PTIOO-Sensor ausgeführt ist. Der Eingang 22g ist ein so genannter RS-485-Eingang. RS-485, auch als TIA-485 bekannt, bezeichnet einen Standard für eine asynchrone serielle Datenübertragung. Dieser Standard ist dem Fachmann bekannt, so dass eine genauere Beschreibung hier entfallen kann. Das breite Spektrum von Messeingängen 22a bis 22g ermöglicht die Kommunikationseinheit 12 flexibel für solche elektrische Geräte einzusetzen, die im Bereich der Elektroenergieübertragung und -Verteilung üblich sind.

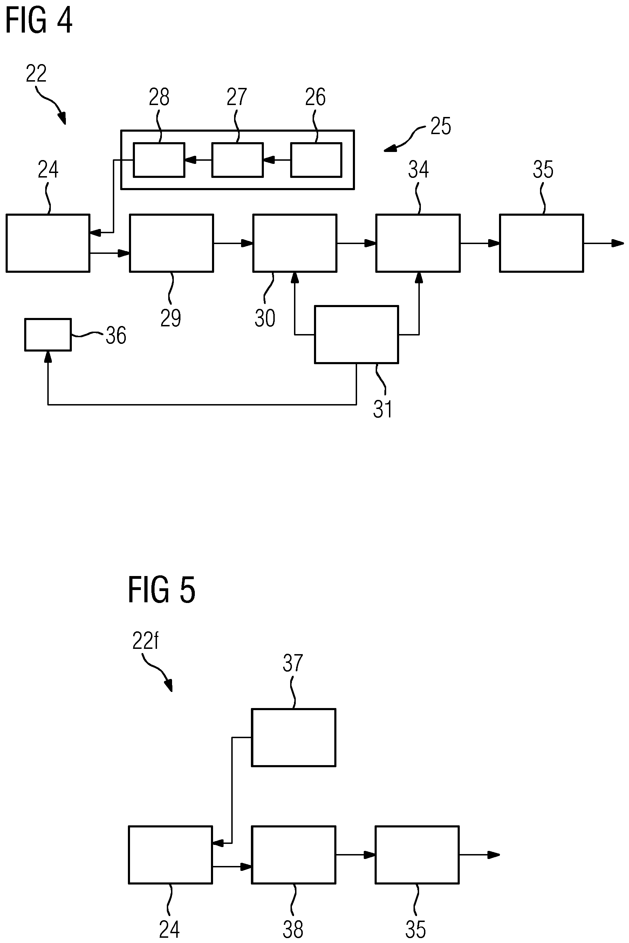

Dabei müssen nicht alle Messeingänge 22a bis 22g tatsächlich verwendet werden. In dem gezeigten Ausführungsbeispiel ist lediglich ein digitaler Eingang mit einem Messsensor 23a verbunden, wohingegen der digitale Eingang 22b frei bleibt und mit keinem Sensor verbunden ist. Der analoge Eingang 22c ist mit einem so genannten 4 - 20mA-Sensor 23c verbunden. Bei dem Sensor 23d, der mit dem analogen Messeingang 22d verbunden ist, handelt es sich um einen so genannten +/-2 OmA-Sensor. Auf die Unterschiede wird später im Zusammenhang mit Figur 4 noch genauer eingegangen werden.

Der analoge Eingang 22e bleibt in dem gezeigten Ausführungsbeispiel ebenfalls frei. Bei dem Sensor 23f handelt es sich um einen so genannten PT-100-Sensor. Der Sensor 23g ist ein RS-485-Sensor, der ausgangsseitig Messsignale gemäß dem RS485-Standard bereitstellt.

Figur 4 zeigt den Aufbau eines analogen Eingangs am Beispiel des analogen Eingangs 22c von Figur 3, wobei jedoch die analogen Eingänge 22d und 22e identisch aufgebaut sind. Der analoge Eingang 22c umfasst eine Steckbuchse 24, die zur Aufnahme eines formkomplementären Steckteils des Sensors 22c einge richtet ist. Um die Anwendungsvielfalt der analogen Eingänge zu erweitern, ist für jeden analogen Eingang eine Energieversorgung 25 vorgesehen, so dass ein aktiv messender Sensor, beispielsweise ein 4-20mA-Stromsensor, mit einer Spannung oder einem Strom versorgt werden kann. Die Energieversorgungseinheit 25 umfasst die eigentliche Energiequelle 26, einen Überstromschutz 27 sowie einen Polarisationsschutz 28. Weiterhin ist ein Überspannungsschutz 29 vorgesehen. Anschließend folgt eine Widerstandseinheit 30, deren innerer Widerstand von einem Wahlschalter 31, von 60 Ohm auf 120 Ohm oder umgekehrt umgestellt werden kann. Dabei ist der Wahlschalter 31 mit einem Ausgleichsglied 34 verbunden, dem wiederum ein Filter, beispielsweise ein Butterworth-Filter 35, nachgeschaltet ist. Der Filter 35 glättet die eingehenden analogen Messsignale, die anschließend unter Gewinnung von Abtastwerten abgetastet werden, woraufhin die Abtastwerte von einem figürlich nicht dargestellten Analog-/Digitalwandler digitalisiert werden. Mit Hilfe des Wahlschalters 31 ist es möglich, den analogen Messeingang 22c von einem so genannten 4 - 2 OmA-Standard auf einen +/-2 OmA-Sensor umzustellen, wobei der jeweils eingestellte Zustand über eine LED-Anzeige 36 außen am Gehäuse optisch angezeigt wird. Die Umstellung erfolgt in dem gezeigten Ausführungsbeispiel selbstständig, so dass die Flexibilität der Kommunikationsbox 12 noch weiter erhöht ist.

Figur 5 zeigt den Eingang für einen PTIOO-Sensor als Widerstandsthermometer 22f genauer. Ein PTIOO-Sensor ist über ein dreigliedriges Signalkabel an die Eingangsbuchse 24 angeschlossen. Eine Stromquelle 37 ist mit der Eingangsbuchse 24 verbunden und stellt den für den PTIOO-Sensor notwendigen Messstrom bereit. Der Eingangsbuchse 24 nachgeschaltet ist eine Widerstandsausgleichseinheit 38 und anschließend wieder eine Filtereinheit 35, welche die für die Digitalisierung notwendige Glättung bereitstellt. Die in den Figuren 4 und 5 ausgangsseitig bereitgestellten geglätteten Messsignale werden von dem Coprozessor, wie weiter oben beschrieben, unter Gewinnung von digitalen Messdaten digitalisiert. Der Coprozessor mittelt die digitalen Messdaten über einen ersten Mittelungsbereich, beispielsweise über 1 Sekunde hinweg, und stellt die gemittelten Messdaten dem Hauptprozessor 13 zur Verfügung, der die weitere Verarbeitung übernimmt. So verfügt der Hauptprozessor 13 beispielsweise über eine figürlich nicht dargestellte Speichereinheit, in welcher die von ihm beispielsweise über eine zweite Mittelungsdauer hinweg gemittelten Mittelwerte gespeichert werden. Die Mittelwerte werden ferner dem GSM-Modul 15 zugeführt (siehe Figur 3), das ausgangsseitig mit einer GSM-Antenne 39 sowie einem Positiongsgeber-Antenne 40 verbunden ist. Sowohl die GSM-Antenne 39 also auch die Positiongsgeber-Antenne 40 sind bevorzugt außerhalb des Gehäuses angeordnet. Mit Hilfe der GSM-Antenne 39 werden die zweimal gemittelten Messdaten über eine Mobilfunkverbindung dem in Figur 1 gezeigten Cloudrechner 14a zur Verfügung gestellt.

Die Positionsgeber-Antenne ist bevorzugt eine GPS Antenne.

Die GPS-Antenne ist Teil eins globalen Positionsbestimmungssystems, das von im Orbit der Erde verteilten Satelliten angepeilt werden kann, so dass dem Cloudrechner 14a auch die Position des Geräts übermittelt werden kann.

Schließlich verfügt die Kommunikationseinheit 12 auch über einen so genannten SIM-Kartenleser 41 (Figur 3), der mit dem GSM-Modul 15 verbindbar ist.

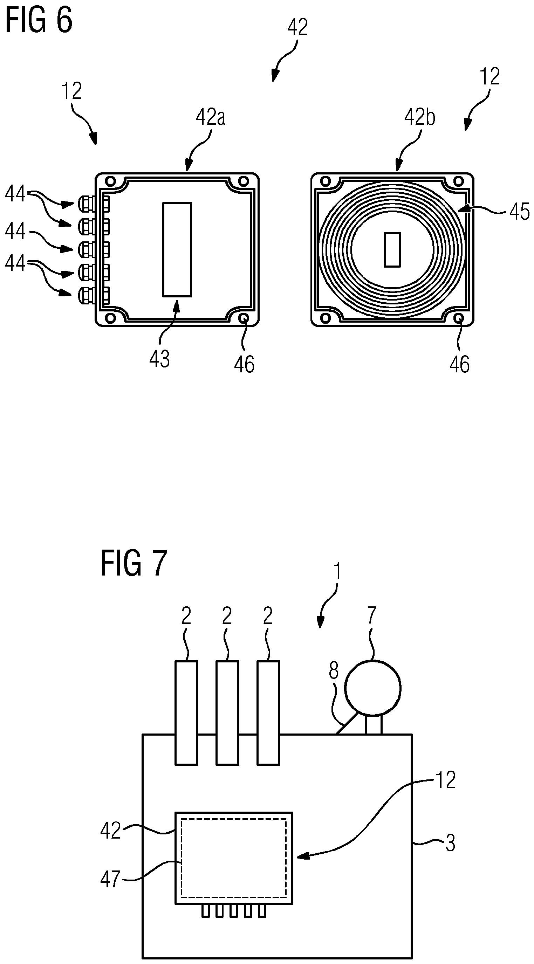

Figur 6 zeigt ein Ausführungsbeispiel eines Schutzgehäuses 42 einer erfindungsgemäßen Kommunikationseinheit 12. Auf der rechten Seite der Figur 6 ist ein Bodenteil 42a und auf der linken Seite ein Deckelteil 42b des Schutzgehäuses 42 jeweils in einer Draufsicht dargestellt. Es ist erkennbar, dass das Bodenteil 42a des Schutzgehäuses 42 eine flache Bodenwand aufweist, an der Befestigungsmittel 43 vorgesehen sind, die zur Befestigung eines figürlich nicht dargestellten inneren Gehäuses in dem Schutzgehäuse 42 dienen, in dem die zuvor beschriebenen elektronischen Komponenten mit Ausnahme der Antennen angeordnet sind. Von der Bodenwand des Bodenteils 42a ragen Seitenwände auf, also aus der Zeichnungsebene heraus, die einen Schutzraum von allen Seiten umgeben. Eine der besagten vier Seitenwände ist mit in einer Reihe nebeneinander angeordneten Zugangsöffnungen 44 ausgerüstet. Die Zugangsöffnungen 44 ermöglichen das Zuführen der mit den Messsensoren verbundenen Signalleitungen an die Eingänge der Kommunikationseinheit 12, die an dem inneren Gehäuse ausgebildet sind. Nicht benötigte Zugangsöffnungen sind mit einem nicht dargestellten Verschlussteil verschlossen. Das Deckelteil 42b verfügt über einen haubenförmig ausgebildeten Kuppelabschnitt 45, der mit seinen Seitenwänden die Seitenwände des Bodens teils 42a an allen Seiten mit etwas Spiel übergreift. Für je de Zuführungsöffnung 44 ist ein Einführungsschlitz an einer Wand des Kuppelabschnitts des Deckelteil 42b vorgesehen.

Nachdem das Gehäuse in dem Bodenteil 42a angeordnet und an diesem befestigt ist, kann das Deckelteil 42b über die Seitenwände des Bodenteils 42a gestülpt und mit diesem beispielsweise durch eine Schraubverbindung mechanisch verbunden werden. Dazu sind in dem Deckelteil 42b Durchgangsbohrungen 46 ausgebildet. Über die im Bodenteil 42a erkennbaren Durchgangsbohrungen kann das Schutzgehäuse 42 zum Beispiel an der Außenseite eines Kessels oder an einem Trockentransformator befestig werden. Das in dem Schutzgehäuse 42 angeordnete Gehäuse ist von diesem vollständig gekapselt und somit vor Schmutz und schädlichen Umwelteinflüssen wie beispielsweise Schnee oder Regen geschützt. Dabei weist der Kuppelabschnitt ausreichend Platz auf, um die GPS- und GPS-Antennen, die nicht in dem inneren Gehäuse angeordnet sind, aufzunehmen. Figur 7 zeigt ein weiteres Ausführungsbeispiel des erfindungsgemäßen elektrischen Geräts, das wieder als Leistungstransformator 1 ausgeführt ist und einen mit Isolierfluid befüllten Kessel 3 aufweist. An dem Kessel 3 ist das Zusatzgehäuse 42 befestigt, in dessen Inneren das Gehäuse 47 durch gestrichelte Linien angedeutet ist.

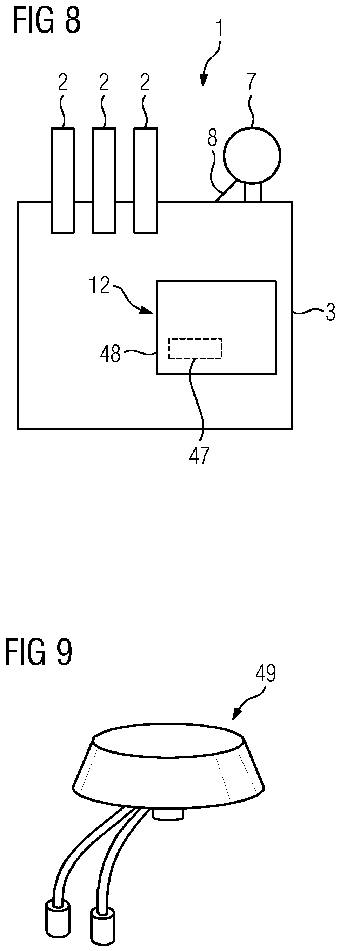

Figur 8 zeigt ein von Figur 7 insoweit abweichendes Ausführungsbeispiel des erfindungsgemäßen elektrischen Geräts 1, als dass die Kommunikationseinheit 12 mit ihrem Gehäuse 47 innerhalb eines Schaltschranks 48 des elektrischen Geräts 1 angeordnet ist. In diesem Fall stellt der Schaltschrank 48 den notwendigen Schutz für die Kommunikationseinheit 12 vor äußeren Einflüssen bereit. Ein zusätzliches Schutzgehäuse ist daher nicht vorgesehen.

Wird das Gehäuse 47 von dem Schutzgehäuse 42 gekapselt, sind die GSM-Antenne und die GPS-Antenne zwar außerhalb des inneren Gehäuses 47 jedoch noch innerhalb des Schutzgehäuses 42 angeordnet. Das Deckelteil 42b des Schutzgehäuses 42 ist entsprechend ausgestaltet.

Im Rahmen der Erfindung ist es jedoch auch möglich die GPS-Antenne 40 und/oder die GSM-Antenne 39 jeweils als Außenantenne auszugestalten, so dass die besagten Antennen 39 bzw. 40 ohne Schutz durch ein zusätzliches Gehäuse beispielsweise an der Außenseite eines Kessels oder einer Außenwand eines Gebäudes befestigt werden kann. Dies ist beispielsweise dann erforderlich, wenn das Gehäuse 47 wie in Figur 7 gezeigt innerhalb eines in der Regel metallischen Schaltschranks 48 angeordnet ist. Der Metallschrank 48 würde in ihm angeordnete Antennen zu stark abschirmen.

Figur 9 zeigt ein Ausführungsbeispiel einer separaten Antenne 49, die sowohl die GSM-Antenne 39 als auch die GPS-Antenne 40 umfasst. Die gezeigte separate Antenne 49 ist als Außenantenne ausgeführt und weist eine äußere Abdeckhaube auf, unter der die besagten Antennen 39, 40 geschützt angeordnet sind. Für jede Antenne 39, 40 ist eine Anschlussleitung unten aus der Abdeckhaube herausgeführt.

## Patentansprüche

1. Elektrisches Gerät (1) zum Anschluss an ein Hochspannungsnetz mit
- einem magnetisierbaren Kern (5),
- wenigstens einer Wicklung (6), die zum Erzeugen eines Magnetfeldes in dem Kern eingerichtet ist, und
- einer Gruppe von Messsensoren (9, 10, 11, 23a-23g), die ausgangsseitig Messsignale bereitstellen,
wobei
wenigstens eine Kommunikationseinheit (12) mit einem Gehäuse (47) vorgesehen ist, in dem ein GSM-Modul (15) sowie mehrere analoge und mehrere digitale Messeingänge (22a-22g) angeordnet sind, wobei mehrere der Messsensoren (23a-23g) mit der jeweiligen Kommunikationseinheit (12) verbunden sind und die jeweilige Kommunikationseinheit (12) zum Verarbeiten der aus den verschiedenen Messsignalen gewonnenen Messdaten eingerichtet ist,
**dadurch gekennzeichnet, dass**
für jeden analogen Eingang (22c-e) eine Energieversorgung (25) umfassend eine Energiequelle (26), einen Überstromschutz (27) und einen Polarisationsschutz (28) vorgesehen ist.

2. Elektrisches Gerät (1) nach Anspruch 1,
**dadurch gekennzeichnet, dass**
die Gruppe von Messsensoren
- einen Wicklungsstromsensor (11), der zum Erfassen eines durch die Wicklung (6) fließenden Wicklungsstromes eingerichtet ist, und
- einen Positionsgeber (40) umfasst, der zur Bestimmung der örtlichen Lage des elektrischen Geräts (1) dient.

3. Elektrisches Gerät (1) nach Anspruch 1 oder 2,
**dadurch gekennzeichnet, dass**
jede Kommunikationseinheit (12) einen Eingang für ein Widerstandsthermometer (23f) aufweist.

4. Elektrisches Gerät (1) nach einem der vorhergehenden Ansprüche,
**dadurch gekennzeichnet, dass**
jede Kommunikationseinheit (12) über einen USB-Anschluss (20) und einen Ethernet-Anschluss (19) verfügt.

5. Elektrisches Gerät (1) nach Anspruch 2 oder nach einem der Ansprüche 3 bis 4, nur wenn diese von Anspruch 2 abhängig sind,
**d a dur c h gekennzeichnet ,** dass
der Positionsgeber außerhalb des Gehäuses (47) der jeweiligen Kommunikationseinheit (12) angeordnet ist.

6. Elektrisches Gerät (1) nach einem der vorhergehenden Ansprüche,
**dadurch gekennzeichnet, dass**
jede Kommunikationseinheit (12) einen internen Zeitgeber aufweist.

7. Elektrisches Gerät (1) nach einem der vorhergehenden Ansprüche,
**gekennzeichnet durch**
einen mit Isolierfluid befüllten Kessel (3), wobei die Gruppe von Sensoren einen Temperatursensor (9) im oberen Bereich des Kessels und einen Temperatursensor (10) im unteren Bereich des Kessels (3) umfasst, die jeweils zum Erfassen der Temperatur des Isolierfluids eingerichtet sind.

8. Elektrisches Gerät (1) nach einem der Ansprüche 1 bis 5,
**dadurch gekennzeichnet, dass**
jede Wicklung (6,15) in einem elektrisch nichtleitenden Festkörper eingebettet und mit einem Wicklungstemperatursensor (23f) bestückt ist, der zum Erfassen der Temperatur der Wicklung (6,15) eingerichtet ist.

9. Elektrisches Gerät (1) nach einem der vorhergehenden Ansprüche,
**dadurch gekennzeichnet, dass**
die Kommunikationseinheit (12) einen Coprozessor (14) aufweist, der eingangsseitig mit den Messeingängen (22a-22g) und ausgangsseitig mit einem Hauptprozessor (13) verbunden ist, wobei eine Speichereinheit vorgesehen ist, die mit dem Hauptprozessor (13) verbunden ist.

10. Elektrisches Gerät (1) nach Anspruch 9,
**dadurch gekennzeichnet, dass**
der Coprozessor (14) zum Sammeln, Abtasten der Messsignale unter Erhalt von Messwerten, Digitalisieren der Messwerte unter Gewinnung von Messdaten, Mitteln der Messdaten und Weitersenden der gemittelten Messdaten an den Hauptprozessor eingerichtet ist.

11. Elektrisches Gerät (1) nach Anspruch 10,
**dadurch gekennzeichnet, dass**
der der Hauptprozessor (1) zum Empfang der gemittelten Messdaten, deren Weiterverarbeitung unter Gewinnung von bearbeiteten Messdaten, dem Speichern der bearbeiteten Messdaten in der Speichereinheit und zum Übersenden bearbeiteter Messdaten an die das GSM-Modul (15) eingerichtet ist.

12. Elektrisches Gerät (1) nach einem der vorhergehenden Ansprüche,
**dadurch gekennzeichnet, dass**
die Kommunikationseinheit (12) über eine Logikeinheit verfügt.

13. Elektrisches Gerät (1) nach Anspruch 12,
**dadurch gekennzeichnet, dass**
die Logikeinheit über das GSM-Modul (15) ansteuerbar ist.

14. Elektrisches Gerät (1) nach einem der vorhergehenden Ansprüche,
**dadurch gekennzeichnet, dass**
die Kommunikationseinheit (12) ein mit Zugangsöffnungen (44) ausgerüstetes Schutzgehäuse (42) aufweist, in dem das Gehäuse (47) vollständig gekapselt angeordnet ist.

15. Elektrisches Gerät (1) nach einem der vorhergehenden Ansprüche,
**dadurch gekennzeichnet, dass**
die Kommunikationseinheit (12) innerhalb eines Schaltschranks (48) angeordnet ist.

## Claims

1. Electrical device (1) for connection to a high-voltage supply system, comprising
- a magnetizable core (5),
- at least one winding (6) which is configured for generating a magnetic field in the core, and
- a group of measurement sensors (9, 10, 11, 23a-23g) which provide measurement signals on the output side,
wherein
at least one communication unit (12) is provided with a housing (47) in which a GSM module (15) and a plurality of analogue measurement inputs and a plurality of digital measurement inputs (22a-22g) are arranged, wherein a plurality of the measurement sensors (23a-23g) are connected to the respective communication unit (12), and the respective communication unit (12) is configured for processing the measurement data obtained from the various measurement signals,
**characterized in that**
an energy supply (25) comprising an energy source (26), overcurrent protection (27) and polarization protection (28) is provided for each analogue input (22c-e).

2. Electrical device (1) according to Claim 1,
**characterized in that**
the group of measurement sensors comprises
- a winding current sensor (11) which is configured to detect a winding current flowing through the winding (6), and
- a position sensor (40) which is used for determining the spatial position of the electrical device (1).

3. Electrical device (1) according to Claim 1 or 2,
**characterized in that**
each communication unit (12) comprises an input for a resistance thermometer (23f).

4. Electrical device (1) according to one of the preceding claims,
**characterized in that**
each communication unit (12) comprises a USB receptacle (20) and an Ethernet receptacle (19).

5. Electrical device (1) according to Claim 2 or according to one of Claims 3 to 4 only when dependent on Claim 2,
**characterized in that**
the position sensor is arranged outside the housing (47) of the respective communication unit (12).

6. Electrical device (1) according to one of the preceding claims,
**characterized in that**
each communication unit (12) comprises an internal timer.

7. Electrical device (1) according to one of the preceding claims,
**characterized by**
a tank (3) filled with insulating fluid, wherein the group of sensors comprises a temperature sensor (9) in the upper area of the tank and a temperature sensor (10) the lower area of the tank (3), which are respectively configured for detecting the temperature of the insulating fluid.

8. Electrical device (1) according to one of Claims 1 to 5,
**characterized in that**
each winding (6, 15) is embedded in an electrically nonconductive solid and is populated with a winding temperature sensor (23f) which is configured for detecting the temperature of the winding (6, 15).

9. Electrical device (1) according to one of the preceding claims,
**characterized in that**
the communication unit (12) comprises a coprocessor (14) which is connected to the measurement inputs (22a-22g) on the input side and to a central processing unit (13) on the output side, wherein a memory unit is provided which is connected to the central processing unit (13).

10. Electrical device (1) according to Claim 9,
**characterized in that**
the coprocessor (14) is configured for collecting, sampling the measurement signals, thereby obtaining measured values, digitizing the measured values, thereby obtaining measurement data, averaging the measurement data, and forwarding the averaged measurement data to the central processing unit.

11. Electrical device (1) according to Claim 10,
**characterized in that**
the central processing unit (1) is configured for receiving the averaged measurement data, further processing said measurement data, thereby obtaining processed measurement data, storing the processed measurement data in the memory unit, and transmitting processed measurement data to the GSM module (15).

12. Electrical device (1) according to one of the preceding claims,
**characterized in that**
the communication unit (12) comprises a logic unit.

13. Electrical device (1) according to Claim 12,
**characterized in that**
the logic unit can be actuated via the GSM module (15).

14. Electrical device (1) according to one of the preceding claims,
**characterized in that**
the communication unit (12) comprises a protective housing (42) which is equipped with access openings (44) in which the housing (47) is completely encapsulated.

15. Electrical device (1) according to one of the preceding claims,
**characterized in that**
the communication unit (12) is arranged inside a switch cabinet (48).

## Revendications

1. Appareil (1) électrique de connexion à un réseau de haute tension comprenant
- un noyau (5) magnétisable,
- au moins un enroulement (6), qui est agencé pour la production d'un champ magnétique dans le noyau, et
- un groupe de capteurs (9, 10, 11, 23a-23g) de mesure, qui donnent des signaux de mesure en sortie,
dans lequel il est prévu au moins une unité (12) de communication ayant un boîtier (47), dans lequel sont disposés un module GSM (15), ainsi que plusieurs entrées analogiques et plusieurs entrées (22a-22g) numériques, dans lequel plusieurs capteurs (23a-23g) de mesure sont reliés à l'unité (12) respective de communication et l'unité (12) respective de communication est agencée pour le traitement des données de mesure obtenues à partir des divers signaux de mesure,
**caractérisé en ce qu'**
il est prévu, pour chaque entrée (22c-e) analogique, une alimentation (25) en énergie comprenant une source (26) d'énergie, une protection (27) à maximum de courant et une protection (28) à la polarisation.

2. Appareil (1) électrique suivant la revendication 1,
**caractérisé en ce que**
le groupe de capteurs de mesure comprend
- un capteur (11) de courant d'enroulement, qui est agencé pour la détection d'un courant d'enroulement passant dans l'enroulement (6), et
- un indicateur (40) de position, qui sert à la détermination de la position dans l'espace de l'appareil (1) électrique.

3. Appareil (1) électrique suivant la revendication 1 ou 2,
**caractérisé en ce que**
chaque unité (12) de communication a une entrée pour un thermomètre (23f) à résistance.

4. Appareil (1) électrique suivant l'une des revendications précédentes,
**caractérisé en ce que**
chaque unité (12) de communication dispose d'une connexion (20) USB et d'une connexion (19) Ethernet.

5. Appareil (1) électrique suivant la revendication 2 ou suivant l'une des revendications 3 à 4, lorsque celles-ci dépendent de la revendication 2,
**caractérisé en ce que**
l'indicateur de position est disposé à l'extérieur du boîtier (47) de l'unité (12) respective de communication.

6. Appareil (1) électrique suivant l'une des revendications précédentes,
**caractérisé en ce que**
chaque unité (12) de communication a une horloge interne.

7. Appareil (1) électrique suivant l'une des revendications précédentes,
**caractérisé par**
une cuve (3) remplie d'un fluide isolant, dans lequel le groupe de capteurs comprend un capteur (9) de température dans la partie supérieure de la cuve et un capteur (10) de température dans la partie inférieure de la cuve (3), qui sont agencés chacun pour la détection de la température du fluide isolant.

8. Appareil (1) électrique suivant l'une des revendications 1 à 5,
**caractérisé en ce que**
chaque enroulement (6, 15) est enrobé dans un corps solide non conducteur de l'électricité et est équipé d'un capteur (23f) de température d'enroulement, qui est agencé pour la détection de la température de l'enroulement (6, 15).

9. Appareil (1) électrique suivant l'une des revendications précédentes,
**caractérisé en ce que**
l'unité (12) de communication a un coprocesseur (14), qui est relié en entrée aux entrées (22a-22g) de mesure et en sortie à un processeur (13) principal, dans lequel il est prévu une unité de mémoire, qui est reliée au processeur (13) principal.

10. Appareil (1) électrique suivant la revendication 9,
**caractérisé en ce que**
le coprocesseur (14) est agencé pour la collecte, l'échantillonnage des signaux de mesure en obtenant des valeurs de mesure, la numérisation des valeurs de mesure en obtenant des données de mesure, la formation de moyennes des données de mesure et l'acheminement des données de mesure mises en moyennes au processeur principal.

11. Appareil (1) électrique suivant la revendication 10,
**caractérisé en ce que**
le processeur (1) principal est agencé pour la réception des données de mesure en moyennes, leur retraitement avec obtention de données de mesure traitées, la mise en mémoire des données de mesure traitées dans l'unité de mémoire et l'envoi des données de mesure traitées au module GSM (15).

12. Appareil (1) électrique suivant l'une des revendications précédentes,
**caractérisé en ce que**
l'unité (12) de communication dispose d'une unité logique.

13. Appareil (1) électrique suivant la revendication 12,
**caractérisé en ce que**
l'unité logique peut être commandée par le module GSM (15).

14. Appareil (1) électrique suivant l'une des revendications précédentes,
**caractérisé en ce que**
l'unité (12) de communication a un boîtier (42) de protection, qui est équipé d'ouvertures (44) d'accès et dans lequel le boîtier (47) est disposé en étant enfermé complètement.

15. Appareil (1) électrique suivant l'une des revendications précédentes,
**caractérisé en ce que**
l'unité (12) de communication est disposée dans une armoire (48) de commande.
